# DEMANDE DE BREVET EUROPEEN

(11) **EP 4 548 802 A1**
(43) Date de publication de la demande: **07.05.2025**
(21) Numéro de dépôt: 24202752.2
(22) Date de dépôt: 26.09.2024
(51) Int. Cl.: A45C 11/00, A45C 13/00, A45C 13/02

(54) **COQUE POUR DISPOSITIF PORTATIF D'ACQUISITION D'EMPREINTES DIGITALES ET/OU PALMAIRES**

(30) Priorité: 31.10.2023 FR 2311894
(71) Demandeur: IDEMIA Public Security France, 92400 Courbevoie (FR)
(72) Inventeur: LEFEBVRE, Rodolphe, 92400 Courbevoie (FR); FOURNIER, Olivier, 92400 Courbevoie (FR); BEZOT, Grégoire, 92400 Courbevoie (FR)
(74) Mandataire: IPS

(57) **Abrégé**

L'invention concerne une coque de protection (12) pour dispositif portatif (10) d'acquisition d'empreintes digitales et/ou palmaires , ladite coque de protection (12) comprend :
- un premier logement (16) adapté à recevoir le dispositif portatif 10) d'acquisition ;
- un deuxième logement (20) comprenant un moyen de rétention 26, 34) de l'extrémité d'un câble de raccordement du dispositif portatif d'acquisition 10) munie d'un connecteur;
- une cloison de séparation (22) entre le premier logement (16) et le deuxième logement (20), ladite cloison de séparation (22) comprend une ouverture (24) de communication entre le premier logement (16) et le deuxième logement (20); ladite ouverture (24) étant adaptée à être traversée par le connecteur du câble de raccordement et à former un joint d'étanchéité autour dudit connecteur.

## Description

### DOMAINE TECHNIQUE

L'invention concerne une coque pour un dispositif portatif d'acquisition d'empreintes digitales et/ou palmaires. La coque comporte un aménagement destiné à recevoir un connecteur d'un câble de raccordement du dispositif portatif à un autre dispositif électronique et/ou à une source d'énergie.

### ÉTAT DE LA TECHNIQUE ANTÉRIEURE

Un dispositif de prise d'empreintes portatif consiste généralement en un boitier électronique comportant une surface d'acquisition munie d'un capteur sur laquelle la main ou une partie d'une main est apposée pour une prise d'empreintes digitales et/ou palmaire.

Il est courant de munir le dispositif d'une coque de protection montée autour du boitier pour protéger celui-ci d'éventuels chocs et des conditions extérieures. Cette coque recouvre l'ensemble du dispositif de prise d'empreinte, mis à part le capteur. La coque peut être constituée par le boîtier du dispositif lui-même.

Afin de récupérer les données du dispositif portatif et/ou de procéder à sa recharge électrique, il est courant de raccorder le dispositif à un autre dispositif électronique ou à une source d'énergie électrique à l'aide d'un câble de raccordement.

Chaque extrémité du câble de raccordement est munie d'un connecteur, par exemple un connecteur USB micro B, USB-A ou USB-C, dont l'une est reçue dans une prise dédiée du dispositif et l'autre dans un autre dispositif électronique ou une source d'énergie.

### PROBLEME TECHNIQUE

D'un encombrement géométrique réduit et ergonomique, le dispositif portatif peut être aisément transporté sur les lieux intérieurs ou extérieur de prise d'empreintes digitales et/ou palmaires.

Un exemple d'utilisation d'un dispositif portatif en extérieur peut être le relevé, par les forces de l'ordre, d'empreintes digitales et/ou palmaires des personnes, notamment suspects et prévenus, à proximité du lieu d'une infraction, d'un délit, ou d'un crime, ou encore lors d'un contrôle d'identité courant. Le dispositif portatif doit alors être robuste et adapté à pouvoir fonctionner de manière optimale quelles que soient les conditions météorologiques et les difficultés d'utilisation par les utilisateurs. Or, les fréquentes sollicitions du dispositif, et surtout lorsqu'elles ont lieu dans des conditions où il peut être malmené, peuvent provoquer des déconnections intempestives du câble de raccordement. Outre la perte de connexion, le câble peut se détériorer plus rapidement. En des conditions humides ou pluvieuses, des infiltrations d'eau peuvent avoir lieu et oxyder tout ou partie des connecteurs et composants électroniques du dispositif.

La liaison entre le dispositif portatif et son câble de raccordement doit donc être résistante aux sollicitations mécaniques et doit permettre le remplacement du câble lorsque celui-ci est détérioré.

### EXPOSÉ DE L'INVENTION

L'invention propose une coque de protection pour dispositif portatif d'acquisition d'empreintes digitales et/ou palmaires, ladite coque de protection comprend :
- un premier logement adapté à recevoir le dispositif portatif d'acquisition ;
- un deuxième logement comprenant un moyen de rétention , de l'extrémité d'un câble de raccordement du dispositif portatif d'acquisition munie d'un connecteur;
- une cloison de séparation entre le premier logement et le deuxième logement, ladite cloison de séparation comprend une ouverture de communication entre le premier logement et le deuxième logement ; ladite ouverture étant adaptée à être traversée par le connecteur du câble de raccordement et à former un joint d'étanchéité autour dudit connecteur.

Le deuxième logement permet à la fois de réaliser un maintien résistant du connecteur et une étanchéité du raccordement entre l'appareil et le connecteur, permettant ainsi une utilisation sous toutes conditions du dispositif portatif.

De préférence, les moyens de rétention sont formés par une encoche dans une paroi extérieure du deuxième logement et un crochet de blocage, ladite encoche et ledit crochet étant situés en regard de l'ouverture et étant aptes à recevoir l'extrémité du câble de raccordement.

De préférence, le crochet est un crochet rapporté sur la paroi extérieure du deuxième logement.

De préférence, le crochet est porté par la paroi extérieure du deuxième logement.

De préférence, l'encoche débouche dans un bord inférieur de la paroi extérieure du deuxième logement.

De préférence, le crochet forme une butée du connecteur du câble lorsque ledit connecteur est reçu dans le deuxième logement.

De préférence, la coque de protection comprend des éléments de serrage destinés à être rapportés sur l'extrémité du câble entre le connecteur, d'une part, et l'encoche et/ou le crochet, d'autre part.

De préférence, la paroi extérieure du deuxième logement comprend des moyens d'agrandissement de l'ouverture de l'encoche et/ou du crochet.

De préférence, les moyens d'agrandissement sont formés par deux orifices situés de part et d'autre de l'encoche et sont aptes à coopérer avec un outil d'écartement.

De préférence, le premier logement forme un boitier de protection du dispositif portatif.

De préférence, la coque de protection est réalisée en un matériau thermoplastique élastomère, de préférence en polyuréthane.

L'invention concerne aussi un système d'acquisition d'empreintes digitales comprenant un dispositif portatif d'acquisition d'empreintes digitales et/ou palmaires, un câble de raccordement muni d'un connecteur et une coque de protection selon l'invention.

### BRÈVE DESCRIPTION DES DESSINS

Fig. 1 est une représentation schématique en perspective d'un dispositif portatif destiné à la capture d'empreintes digitales et palmaires qui est installé dans une coque de protection selon l'invention.
Fig. 2 est une vue de dessous de l'ensemble représenté à la Fig. 1, montrant le deuxième logement destiné à recevoir l'extrémité du câble de raccordement.
Fig. 3 est une vue en détail à plus grande échelle du deuxième logement de la coque de protection, montrant l'ouverture formée dans la cloison de séparation et montrant le crochet et l'encoche de la paroi extérieure.
Fig. 4 est une vue du détail de la Fig. 3 selon un autre angle de vue, illustrant plus en détails le crochet et l'encoche de la paroi extérieure.
Fig. 5 est une vue similaire à celle de la Fig. 4, illustrant l'extrémité d'un câble de raccordement logé dans le deuxième logement.

### EXPOSÉ DÉTAILLÉ DE L'INVENTION

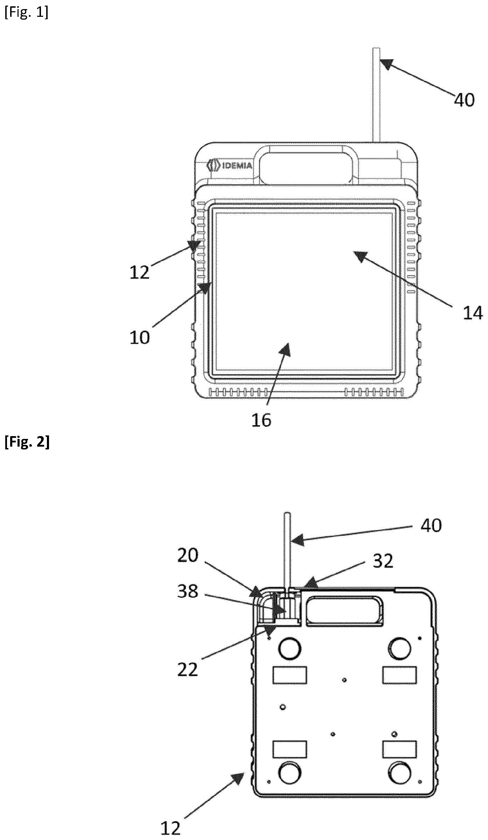

On a représenté à la Fig. 1 un dispositif portatif 10 destiné de préférence à la capture d'empreintes digitales et palmaires. Il comporte une surface supérieure 14 d'acquisition munie d'un capteur sur laquelle la main ou une partie d'une main est apposée pour une prise d'empreintes digitales et/ou palmaire.

Le dispositif portatif 10 comporte un port de raccordement à un autre dispositif électronique tel que par exemple un ordinateur portable et/ou à une source d'énergie. Ce port de raccordement est, par exemple mais non limitativement, du type USB micro B, USB-A ou USB-C.

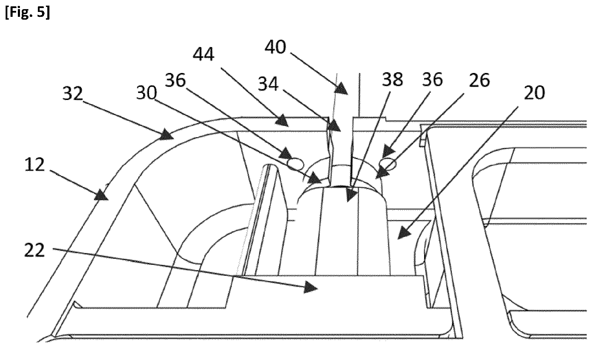

En référence à la Fig. 5, ce port de raccordement est destiné à coopérer avec un connecteur 38 complémentaire monté à une extrémité d'un câble 40 de raccordement du dispositif portatif 10 vers un autre dispositif électronique et/ou à une source d'énergie.

Le dispositif portatif 10 est destiné à être utilisé en extérieur et sous toutes conditions. Il est à cet effet associé à une coque de protection 12.

La coque de protection 12 est de forme similaire à celle du dispositif portatif 10.

Elle délimite un premier logement 16 de forme et dimensions complémentaires de celles du dispositif portatif 10 et qui est adapté à recevoir le dispositif portatif 10.

La face supérieure du premier logement 16 est ouverte, pour permettre à la surface supérieure 14 du dispositif portatif 10 d'être accessible.

Le premier logement 16 forme un boitier de protection du dispositif portatif 10.

La coque de protection 12 comporte un deuxième logement 20 qui est destiné à recevoir le connecteur 38 du câble 40 de raccordement.

La face inférieure du deuxième logement 20 est ouverte pour permettre l'accès au volume intérieur du deuxième logement 20, afin d'y introduire ou d'y extraire le connecteur 38. Le deuxième logement est ouvert à sa face inférieure pour que cette ouverture soit discrète vis-à-vis de l'utilisateur.

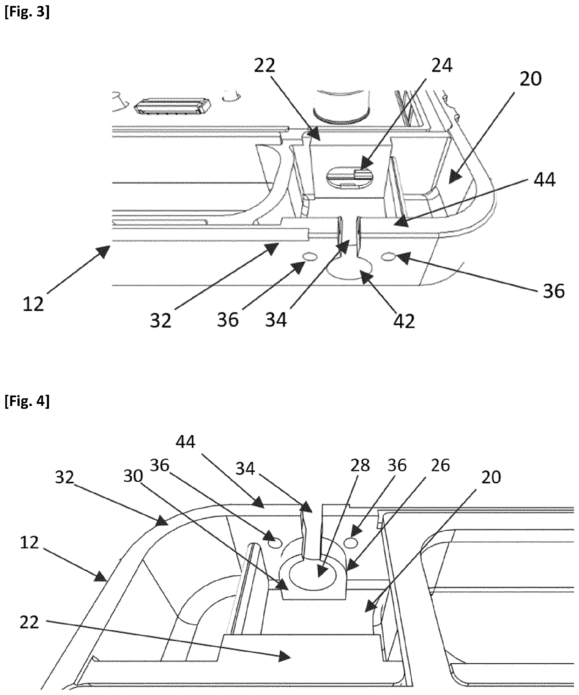

Comme illustré sur la Fig. 3, la coque de protection 12 comporte une cloison de séparation 22 située entre le premier logement 16 et le deuxième logement 20 et qui sépare leurs volumes intérieurs.

La cloison 22 comporte une ouverture 24 de communication entre le premier logement 16 et le deuxième logement 20.

Cette ouverture 24 est adaptée à être traversée par le connecteur 38 du câble 40 de raccordement lorsque le connecteur 38 est mis en place dans le deuxième logement 20.

La coque de protection 12 est conçue pour assurer l'étanchéité entre l'ouverture 24 et le connecteur 38. Selon un premier aspect, cette étanchéité est assurée par l'ouverture 24 elle-même, par exemple par ses dimensions plus petites que celles du connecteur 38. Cela permet d'enserrer le connecteur 38 par les bords internes de l'ouverture 24 et donc d'assurer une certaine étanchéité.

Selon une variante de réalisation, l'ouverture 24 comporte des moyens permettant de former un joint d'étanchéité autour dudit connecteur 38 afin de garantir une étanchéité au niveau du port de raccordement du dispositif portatif 10. Ces moyens d'étanchéité consistent par exemple en un joint du type torique dont la forme et les dimensions sont adaptées à l'ouverture 24.

En référence aux Fig. 4 et 5, la coque de protection 12 comporte aussi des moyens de rétention de l'extrémité du câble 40 de raccordement. Ces moyens sont agencés dans le deuxième logement 20.

Selon un premier aspect, les moyens de rétention comportent un crochet de rétention 26 qui est apte à recevoir l'extrémité du câble 40 de raccordement.

Le crochet 26 est ouvert vers le bas pour permettre un engagement du câble 40 lors de la mise en place du connecteur 38 dans le deuxième logement 20. Le crochet 26 délimite un logement 28 de forme et dimensions sensiblement égales à celles du câble 40. La largeur de l'ouverture supérieure du crochet 26 est en outre inférieure à la largeur du câble 40, permettant ainsi la rétention du câble 40 dans le crochet 26.

Sur les figures, le câble 40 est représenté avec une section circulaire, le logement délimité par le crochet 26 est de préférence de forme circulaire également.

Comme visible à la Fig. 3, le crochet 26 est situé en regard de l'ouverture 24, c'est-à-dire qu'il est aligné avec l'ouverture 24, pour éviter que l'extrémité du câble 40 de raccordement ne subisse une flexion lorsqu'elle est installée dans le deuxième logement 20.

Le crochet 26 comporte en outre une face 30 située en vis-à-vis de la cloison 22. La distance entre la face du crochet 26 et la cloison 22 est définie pour que le connecteur 38, lorsqu'il est mis en place dans le deuxième logement 20 et est raccordé au port du dispositif portatif 10, soit en butée contre le crochet 26.

Cette mise en butée du connecteur 38 contre le crochet 26 ainsi que la coopération du câble 40 dans le crochet 26 permettent d'assurer un maintien pérenne de l'extrémité du câble 40 dans le deuxième logement 20 et ainsi éviter toute déconnexion non souhaitée du connecteur 38 d'avec le dispositif portatif 10.

Selon une variante de réalisation, des moyens de serrage sont introduits dans le deuxième logement sur l'extrémité du câble 40 de raccordement pour bloquer le connecteur 38 en position dans le deuxième logement 20. Ces moyens de serrage sont par exemple disposés entre le connecteur 38et la face 30 du crochet 26. Ainsi, ils bloquent le connecteur 38 en position dans le deuxième logement 20. Selon encore une autre variante, les éléments de serrage sont disposés sur l'extrémité du câble 40 entre le connecteur 38 et l'encoche 34.

La coque de protection 12 comporte une paroi extérieure 32 qui délimite le deuxième logement 20. Cette paroi extérieure est parallèle et est située à distance de la cloison 22 séparant le premier logement 16 et le deuxième logement 20.

De préférence, le crochet 26 est solidarisé à cette paroi extérieure 32, soit en étant réalisé en une même pièce avec la paroi extérieure 32, soit en consistant en un élément rapporté sur la paroi extérieure 32.

La paroi extérieure 32 comporte en outre une encoche 34 qui débouche vers le bas dans le bord inférieur 44 de la paroi extérieure 32. Cette encoche 34 est destinée être traversée par le câble 40 de raccordement pour permettre l'introduction du câble 40 dans le crochet 26 et dans l'encoche.

De préférence, en référence à la Fig. 3, l'encoche 34 comporte un fond 42 de forme et de dimensions sensiblement égales à celles du câble 40 et qui est coaxial au logement 28 du crochet 26. Le reste de l'encoche 34, qui s'étend vers le bas depuis le fond vers le bord inférieur 44 de la paroi extérieure 32, où l'encoche 34 débouche, est de largeur sensiblement inférieure à la largeur du câble 40, de manière similaire au crochet 26.

Les dimensions du crochet 26 sont définies pour qu'il puisse réaliser un maintien ferme de l'extrémité du câble 40 de raccordement, quelles que soient les sollicitations auxquelles il est soumis.

Pour permettre un retrait du connecteur 38 hors du deuxième logement 20, des moyens permettant de produire un écartement manuel du crochet 26 et de l'encoche 34 sont prévus.

Selon un mode de réalisation préféré, en référence aux Fig. 3 et 4, ces moyens d'écartement consistent en deux orifices 36 formés dans la paroi extérieure 32, qui sont répartis de part et d'autre de l'encoche 34.

Ces orifices 36 sont destinés à recevoir des parties complémentaires d'un outil d'écartement tel que par exemple les extrémités d'une pince à anneau élastique. Grâce à cet outil d'écartement, il est procédé à la déformation élastique de la paroi extérieure 32 et du crochet 26. Le crochet 26 et l'encoche 34 s'écartent. La largeur de l'encoche 34 et du crochet 26 peut alors être rendue supérieure à celle du câble 40, permettant ainsi son extraction, ou son insertion hors/dans le logement 28 du crochet 26.

La coque de protection 12 et le crochet 26, si celui-ci consiste en un élément rapporté, sont réalisés en matériau déformable élastiquement. De préférence, ils sont réalisés en un matériau thermoplastique élastomère, de préférence en polyuréthane.

Selon un deuxième aspect de l'invention, il est fourni un système d'acquisition d'empreintes digitales comprenant un dispositif portatif 10 d'acquisition d'empreintes digitales et/ou palmaires et une coque de protection selon l'un des quelconques modes de réalisation décrits précédemment. Le dispositif portatif 10 peut être monté dans la coque de protection 12, notamment dans le premier logement16, de manière telle que sa surface supérieure 14 est libre d'accès.

Le système d'acquisition peut être muni d'un câble 40 de raccordement amovible. Ce câble comprend à une de ses extrémités un connecteur 38 apte à être raccordé à un port du dispositif portatif 10. L'extrémité du câble 40 de raccordement est reçue dans le deuxième logement 20 de la coque de protection 12.

Le connecteur 38 est raccordé au port du dispositif portatif 10 en traversant l'ouverture 24 de la cloison de séparation 22 et il est bloqué contre toute déconnection par sa butée contre le crochet 26 ou par les éléments de serrage.

L'extrémité du câble 40 est en outre reçue et bloquée dans le crochet 26 et l'encoche 34.

Enfin, la coopération du câble 40 avec l'ouverture 24 est étanche, pour empêcher que de l'humidité ne traverse l'ouverture 24.

## Revendications

1. Coque de protection (12) pour dispositif portatif (10) d'acquisition d'empreintes digitales et/ou palmaires , ladite coque de protection (12) comprend :
- un premier logement (16) adapté à recevoir le dispositif portatif (10) d'acquisition ;
- un deuxième logement (20) comprenant un moyen de rétention (26, 34) de l'extrémité d'un câble de raccordement du dispositif portatif d'acquisition (10) munie d'un connecteur;
- une cloison de séparation (22) entre le premier logement (16) et le deuxième logement (20), ladite cloison de séparation (22) comprend une ouverture (24) de communication entre le premier logement (16) et le deuxième logement (20); ladite ouverture (24) étant adaptée à être traversée par le connecteur du câble de raccordement et à former un joint d'étanchéité autour dudit connecteur.

2. Coque de protection (12) selon la revendication 1, telle que les moyens de rétention sont formés par une encoche (34) dans une paroi extérieure (32) du deuxième logement (20) et un crochet de blocage (26), ladite encoche (34) et ledit crochet (26) étant situés en regard de l'ouverture (24) et étant aptes à recevoir l'extrémité du câble de raccordement.

3. Coque de protection (12) selon la revendication 2, telle que le crochet (26) est un crochet rapporté sur la paroi extérieure (32) du deuxième logement (20).

4. Coque de protection (12) selon la revendication 2, telle que le crochet (26) est porté par la paroi extérieure (32) du deuxième logement (20).

5. Coque de protection (12) selon l'une des revendications 2 à 4, telle que l'encoche (34) débouche dans un bord inférieur (44) de la paroi extérieure (32) du deuxième logement (20).

6. Coque de protection (12) selon l'une des revendications 2 à 5, telle que le crochet (26) forme une butée du connecteur du câble lorsque ledit connecteur est reçu dans le deuxième logement (20).

7. Coque de protection (12) selon l'une des revendications 2 à 6, telle qu'elle comprend des éléments de serrage destinés à être rapportés sur l'extrémité du câble entre le connecteur, d'une part, et l'encoche (34) et/ou le crochet (26), d'autre part.

8. Coque de protection (12) selon l'une quelconque des revendications 2 à 7, telle que la paroi extérieure (32) du deuxième logement (20) comprend des moyens (36) d'agrandissement de l'ouverture de l'encoche (34) et/ou du crochet (26).

9. Coque de protection 12) selon la revendication précédente, telle que les moyens d'agrandissement sont formés par deux orifices (36) situés de part et d'autre de l'encoche (34) et sont aptes à coopérer avec un outil d'écartement.

10. Coque de protection (12) selon l'une quelconque des revendications précédentes, telle que le premier logement (16) forme un boitier de protection du dispositif portatif (10).

11. Coque de protection (12) selon l'une quelconques des revendications précédentes, telle qu'elle est réalisée en un matériau thermoplastique élastomère, de préférence en polyuréthane.

12. Système d'acquisition d'empreintes digitales comprenant un dispositif portatif (10) d'acquisition d'empreintes digitales et/ou palmaires, un câble de raccordement muni d'un connecteur et une coque de protection (12) selon l'une quelconque des revendications 1 à 11.
